# EUROPEAN PATENT APPLICATION

(11) **EP 3 125 659 A1**
(43) Date of publication of application: **01.02.2017**
(21) Application number: 16178386.5
(22) Date of filing: 07.07.2016
(51) Int. Cl.: H05K 7/20

(54) **CABINET FOR ELECTRIC DEVICE HAVING COOLING STRUCTURE**

(30) Priority: 28.07.2015 KR 20150106667
(71) Applicant: LSIS Co., Ltd., Gyeonggi-do 14119 (KR)
(72) Inventor: HWANG, Soo-Yong, 14118 Gyeonggi-do (KR)
(74) Representative: Zacco Sweden AB

(57) **Abstract**

The present invention relates to a cabinet (100) for electric devices and, more particularly, to a cabinet for electric devices which is capable of regulating flow of air employed as a cooling medium to uniformly cool the interior of the cabinet.

The cabinet (100) includes a plurality of device accommodation spaces (120) for accommodating the electric devices (12) in a stacking manner, a ventilation duct for discharging heat generated from the device accommodation spaces, a heat dissipation fan for discharging hot air from the ventilation duct, and a plurality of connection ducts for connecting the device accommodation spaces to the ventilation duct, wherein a flow rate and flow velocity of air passing through each of the connection ducts is adjusted by differentiating flow resistances in the connection ducts provided to the respective layers from each other.

## Description

### BACKGROUND

### 1. Technical Field

The present invention relates to a cabinet for electric devices and, more particularly, to a cabinet for electric devices which is capable of regulating flow of air employed as a cooling medium to uniformly cool the interior of the cabinet.

### 2. Description of the Related Art

A cabinet for electric devices contains multiple devices generating heat. The cabinet has a structure that forcibly cools the devices using air.

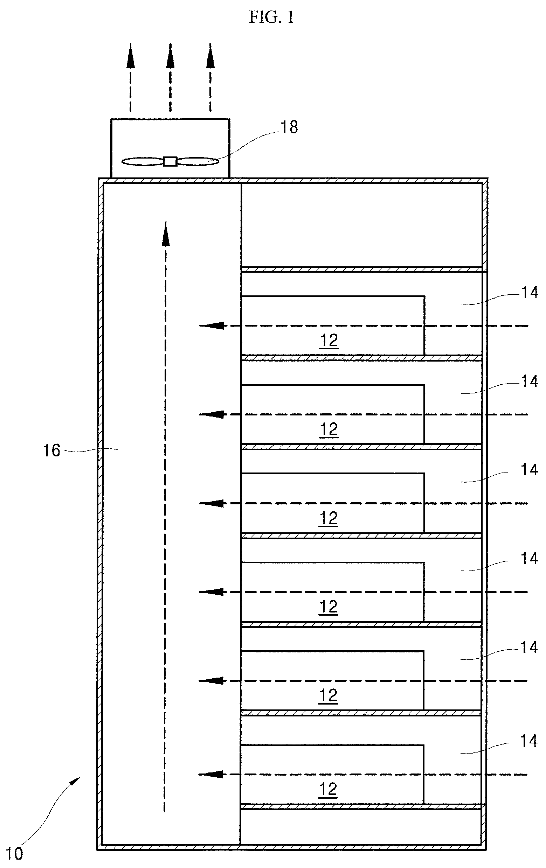

Fig. 1 is a view illustrating configuration of a conventional cabinet for electric devices based on forced cooling.

As shown in Fig. 1, a cabinet 10 for electric devices includes device accommodation spaces 14 forming multiple layers for accommodating electric devices 12, and a ventilation duct 16 communicating with the device accommodation spaces 14 in the respective layers.

The front of each device accommodation space 14 is provided with an introduction portion for introducing external air into the device accommodation space 14, and a heat dissipation fan 18 for discharging hot air from the ventilation duct 16 is provided to an upper portion of the ventilation duct 16.

The cabinet 10 for electric devices cools contained devices by introducing external air thereinto. The pressure in the ventilation duct 16 is lowered by operation of the heat dissipation fan 18. When the pressure in the ventilation duct 16 is lowered, air in the respective device accommodation spaces is drawn into the ventilation duct 16 having a lowered pressure. As air in the respective device accommodation spaces is drawn into the ventilation duct 16, the pressure of the respective device accommodation spaces is lowered. Thereby, external air is introduced into the respective device accommodation spaces 14 again through the introduction portions to cool the devices.

In the ventilation duct 16, the pressure of air varies with the distance from the heat dissipation fan 18. More specifically, a higher negative pressure is generated at an upper portion close to the dissipation fan 18 than at a lower portion far from the heat dissipation fan 18.

In other words, as the distance between a device accommodation space and the heat dissipation fan 18 increases, the flow rate and flow velocity of air introduced into device accommodation space decrease and thus the degree of cooling is lowered. Accordingly, the cabinet 10 cannot implement uniform cooling.

Conventionally, in the case where the heat dissipation fan is installed at an upper portion of the cabinet, the capacity of the heat dissipation fan 18 is increased in order to increase the degree of cooling of the device accommodation spaces positioned below the heat dissipation fan. In this case, upper device accommodation spaces are excessively cooled, and a high specification is required for the heat dissipation fan 18 in order to increase the capacity of the heat dissipation fan 18. This results in unnecessary increase of product costs and noise.

### SUMMARY

It is an aspect of the present invention to provide a cabinet for electric devices which is capable of individually adjusting the flow rate and flow velocity of air in each device accommodation space to effectively and forcibly cool the electric devices using introduced external air.

In accordance with one aspect of the present invention, a cabinet for electric devices includes a plurality of device accommodation spaces defining a plurality of layers for accommodating the electric devices, and a plurality of connection ducts provided to a ventilation side of the device accommodation spaces, wherein each of the connection ducts includes an introduction port connected to a corresponding one of the device accommodation spaces and a discharge port, wherein a flow rate and flow velocity of air passing through each of the connection ducts is adjusted by differentiating flow resistances in the connection ducts provided to the respective layers from each other by differing areas of the discharge ports from each other according to the layers.

Preferably, the cabinet for electric devices includes a ventilation duct for discharging heat generated from the device accommodation spaces, and a heat dissipation fan for discharging hot air from the ventilation duct, wherein the discharge ports of the connection ducts are connected to the ventilation duct.

Preferably, the areas of the discharge ports of the connection ducts are adjustable.

The discharge port of each of the connection ducts may be formed by a pair of hinge-coupled adjustment segments, each of the adjustment segments having a square bracket-shaped cross section.

In accordance with another aspect of the preservation, a cabinet for electric devices includes a plurality of device accommodation spaces defining a plurality of layers for accommodating the electric devices, and a plurality of connection ducts provided to a ventilation side of the device accommodation spaces, wherein each of the connection ducts includes a damper for adjusting a flow resistance therein, wherein a flow rate and flow velocity of air passing through each of the connection ducts is adjusted by differentiating the flow resistances caused by the dampers from each other according to the layers.

Preferably, an opening rate is adjustable by adjusting an angle of each of the dampers.

According to embodiments of the present invention, a cabinet for electric devices has a structure for cooling electric devices accommodated in the device accommodation spaces using external air introduced into the cabinet. As flows of air in the device accommodation spaces of respective layers are individually adjustable, the interior of the cabinet may be uniformly cooled.

According to embodiments of the present invention, a cabinet for electric devices can adjust the degree of cooling of each layer using connection ducts. Accordingly, the cooling power of the heat dissipation fan may be uniformly or variably transferred to the respective layers.

### BRIEF DESCRIPTION OF THE DRAWINGS

Fig. 1 is a view illustrating configuration of a conventional cabinet for electric devices based on forced cooling.
Fig. 2 is a view illustrating configuration of a cabinet for electric devices according to a first embodiment of the present invention.
Fig. 3 is a cross-sectional view illustrating connection ducts provided to the cabinet according to the first embodiment of the present invention.
Fig. 4 is a view illustrating configuration of a cabinet for electric devices according to a second embodiment of the present invention.
Fig. 5 is a cross-sectional view illustrating connection ducts provided to the cabinet according to the second embodiment of the present invention.
Fig. 6 is a view illustrating configuration of a cabinet for electric devices according to a third embodiment of the present invention.
Fig. 7 is a cross-sectional view illustrating connection ducts provided to the cabinet according to the third embodiment of the present invention.

### DETAILED DESCRIPTION

Terms or phrases used in this disclosure and appended claims should not be construed as having only meaning known to those skilled in the art or defined in dictionaries, and should be interpreted as having a meaning that is consistent with the spirit of the present invention in a sense that the inventor can properly define the terms to describe the present invention in the best mode. Hereinafter, embodiments of the present invention will be described in detail with reference to the accompanying drawings. It should be understood that the present invention is not limited to the following embodiments, and that the embodiments are provided for illustrative purposes only. The scope of the invention should be defined only by the accompanying claims and equivalents thereof.

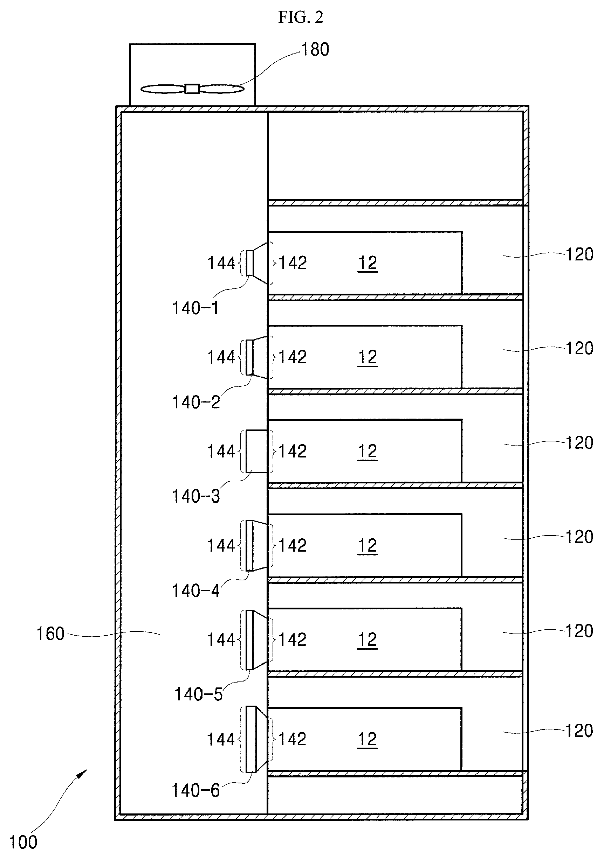

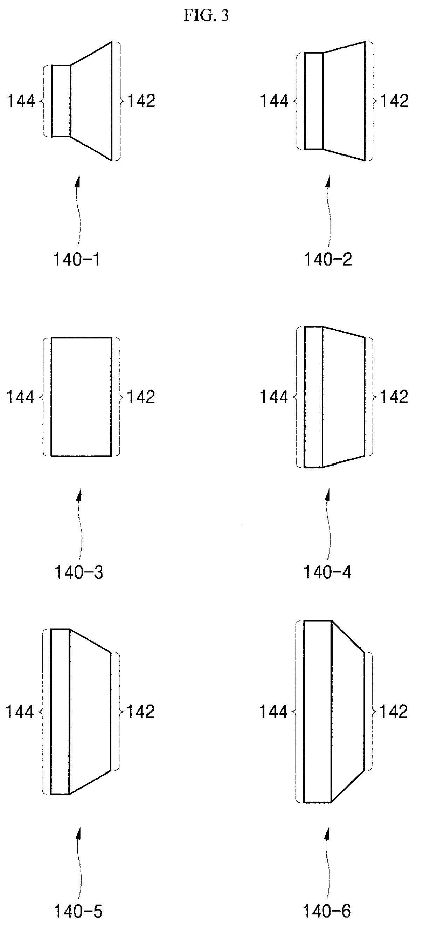

Fig. 2 is a view illustrating configuration of a cabinet for electric devices according to a first embodiment of the present invention, and Fig. 3 is a cross-sectional view illustrating connection ducts provided to the cabinet according to the first embodiment of the present invention.

Referring to Fig. 2, the cabinet 100 for electric devices according to the first embodiment includes device accommodation spaces 120 of multiple layers for accommodating electric devices 12, a ventilation duct 160 for discharging heat generated from the device accommodation spaces 120, a heat dissipation fan 180 for discharging hot air from the ventilation duct 160, and connection ducts 140-1, 140-2, 140-3, 140-4, 140-5, and 140-6 for connecting the device accommodation spaces 120 in the respective layers to the ventilation duct 160.

By adjusting the flow resistances in the connection ducts 140-1, 140-2, 140-3, 140-4, 140-5, and 140-6 provided to the respective layers, the flow rate and flow velocity of cooling air passing through each of the connection ducts 140-1, 140-2, 140-3, 140-4, 140-5, and 140-6 may be adjusted.

As described above, the pressure in the ventilation duct 160 varies with the distance from the heat dissipation fan 180. The present invention is intended to eliminate the difference in the degree of cooling resulting from the difference in pressure among positions, using the connection ducts 140-1, 140-2, 140-3, 140-4, 140-5, and 140-6.

Each of the connection ducts 140-1, 140-2, 140-3, 140-4, 140-5, and 140-6 employed in the present invention includes an introduction port 142 connected to the corresponding one of the device accommodation spaces 120 and a discharge port 144 connected to the ventilation duct 160 such that air can flow from the device accommodation spaces 120 to the ventilation duct 160 only through the connection ducts 140-1, 140-2, 140-3, 140-4, 140-5, and 140-6.

In this structure, the flow rates and flow velocities of air passing through the connection ducts 140-1, 140-2, 140-3, 140-4, 140-5, and 140-6 may be adjusted by changing the flow resistances in the connection ducts 140-1, 140-2, 140-3, 140-4, 140-5, and 140-6. Thereby, the degree of cooling of each device accommodation space 120 may be individually adjusted.

In the first embodiment, various kinds of connection ducts 140-1, 140-2, 140-3, 140-4, 140-5, and 140-6 are used to adjust the flow rate and flow velocity of air in each layer.

As shown in the figures, each of the connection ducts 140-1, 140-2, 140-3, 140-4, 140-5, and 140-6 is provided with the introduction port 142 and discharge port 144. The instruction ports 142 are connected to the device accommodation spaces 120, and the discharge ports 144 are connected to the ventilation duct 160. In this structure, the introduction ports 142 have the same cross-sectional area, while the cross-sectional area of the discharge port 144 is adjusted. Thereby, the flow resistances in the connection ducts 140-1, 140-2, 140-3, 140-4, 140-5, and 140-6 may be adjusted.

As shown in the figures, when the heat dissipation fan 180 is arranged at the upper end of the ventilation duct 160, the cross-sectional area of a discharge port 144 at one position is set to be smaller than that of another discharge port 144 at a lower position. Thereby, air flow resistance may increase as air flow up to an upper layer where a higher negative pressure is generated. Thereby, air can flow through the respective layers with a constant flow rate and flow velocity.

In the illustrated embodiment, the introduction ports of the connection ducts 140-1, 140-2, 140-3, 140-4, 140-5, and 140-6 are formed with six different introduction angles such that the introduction angles of neighboring connection ducts differ from each other by 15°. Alternatively, the discharge ports may be formed with different discharge angles. The angular difference between neighboring connection ducts and the number of different angles may be properly changed when necessary.

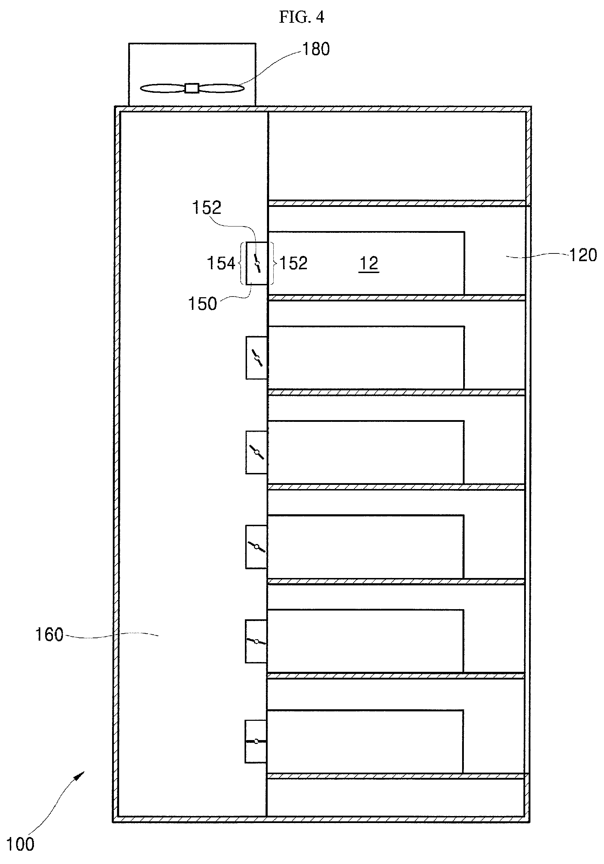

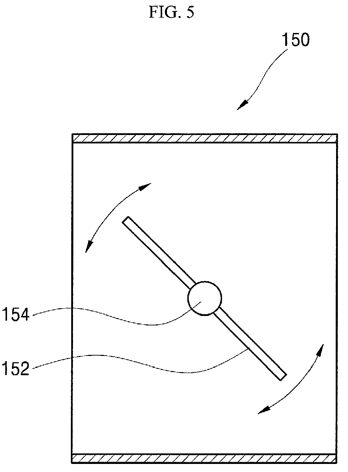

Fig. 4 is a view illustrating configuration of a cabinet for electric devices according to a second embodiment of the present invention, and Fig. 5 is a cross-sectional view illustrating connection ducts provided to the cabinet according to the second embodiment of the present invention.

Referring to Fig. 5, each of the connection ducts 150 applied to the cabinet of the second embodiment is provided therein with a damper 152 for adjusting the flow resistance.

In the first embodiment, various kinds of connection ducts 140-1, 140-2, 140-3, 140-4, 140-5, and 140-6 are installed in the respective layers to adjust the degree of cooling in each layer. In the second embodiment, the same connection duct 150 is applied to each layer, and the flow resistance in each layer may be adjusted by adjusting the damper 152 of each connection duct 150.

As shown in Fig. 5, the damper 152 is provided in the connection duct 150 and connected to a hinge shaft 154 such that the angle of the damper 152 is adjustable. The opening rate of the connection duct 150 may be adjusted by adjusting the angle of the damper 152.

As shown in Fig. 4, the lowest connection duct is given the maximum opening rate, and the upper connection ducts are given lower opening rates such that the opening rate of one connect duct is higher than the opening rate of another connection duct positioned at higher level. The external air introduced into the respective device accommodation spaces may be regulated such that the flow rate and flow velocity of external air does not vary among the device accommodation spaces.

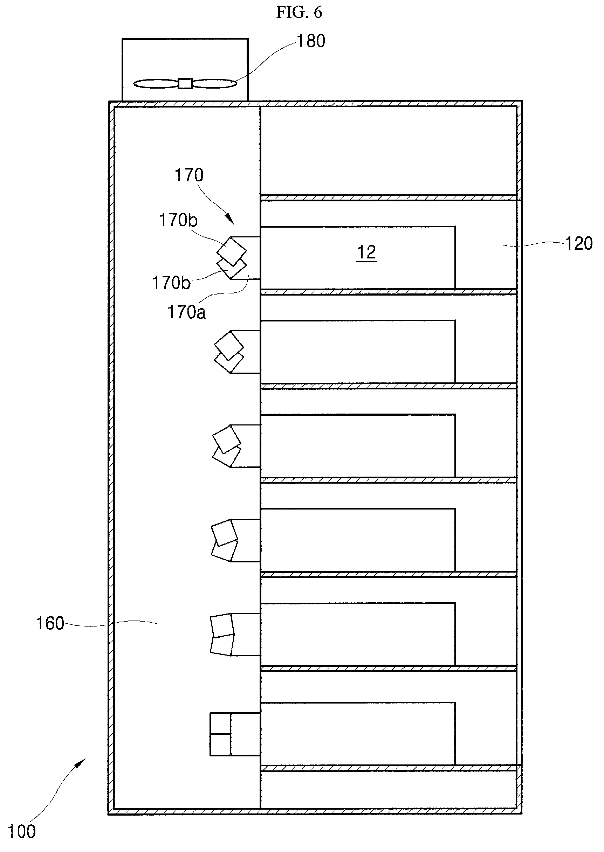

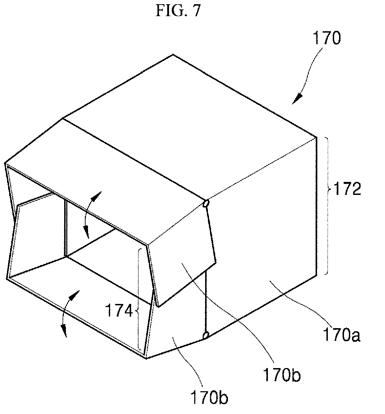

Fig. 6 is a view illustrating configuration of a cabinet for electric devices according to a third embodiment of the present invention, and Fig. 7 is a cross-sectional view illustrating connection ducts provided to the cabinet according to the third embodiment of the present invention.

Referring to Fig. 7, each of the connection ducts 170 according to the third embodiment includes an introduction port 172 connected to a corresponding one of the device accommodation spaces 120 and a discharge port 174 connected to the ventilation duct. Herein, the cross-sectional area of the discharge port 174 is adjustable. Similar to the second embodiment, the flow resistance of air may be adjusted using a single connection duct 170.

As shown in the figures, the connection duct 170 includes a connection duct body 170a defining an introduction port and a pair of adjustment segments 170b hinge-coupled to the connection duct body 170a. The adjustment segments 170b have a square bracket-shaped cross section and are arranged engaged with each other. Thereby, the cross-sectional area of the discharge port 174 may be adjusted by adjusting the gap between the adjustment segments 170b.

Referring to Fig. 6, the cabinet 100 for electric devices according to the third embodiment is installed such that the respective device accommodation spaces 120 communicate with the ventilation duct 160 using the connection ducts 170. The gap between the adjustment segments 170b may be adjusted in each layer to obtain a uniform air flow in the device accommodation spaces 120 in the respective layers.

As shown in the figures, the gap between the adjustment segments 170b may be adjusted such that the gap in one layer is narrower than the gap in a lower layer such that the flow resistance of air passing through a connection duct is higher than the flow resistance of air passing through a lower connection duct. Thereby, external air may be uniformly introduced and circulated in the device accommodation spaces 120 of the respective layers. Accordingly, the entire interior of the cabinet 100 may be uniformly cooled.

Typically, the amounts of heat generated from the electric devices in the respective layers are similar to each other. Accordingly, a uniform air flow may be produced in the respective device accommodation spaces in the cabinet regardless of the distance of the divisive accommodation spaces from the heat dissipation fan 180.

It's possible that different amounts of heat are generated from electric devices installed in the respective layers. In this case, the flow rate and flow velocity necessary for cooling of the electric devices in the respective layers may differ from one layer to another. In this case, the flow rate and flow velocity of air necessary for each layer may be adjusted in a manner that the flow resistance of a connection duct installed in a layer producing a large amount of heat is relatively decreased, and the flow resistance of a connection duct installed in a layer producing a small amount of heat is relatively increased.

The embodiments described above should be construed in all aspects as illustrative and not restrictive. The scope of protection sought by the present invention should be determined by the appended claims and their equivalents, and all changes coming within the meaning and equivalency range of the appended claims are intended to be embraced therein.

## Claims

1. A cabinet(100) for electric devices, the cabinet comprising:
a plurality of device accommodation spaces(120) defining a plurality of layers for accommodating the electric devices(12); and
a plurality of connection ducts(140-1,140-2,140-3,140-4,140-5,140-6) provided to a ventilation side of the device accommodation spaces(120),
wherein each of the connection ducts(140-1,140-2,140-3,140-4,140-5,140-6) comprises an introduction port(142) connected to a corresponding one of the device accommodation spaces(120) and a discharge port(144),
wherein a flow rate and flow velocity of air passing through each of the connection ducts is adjusted by differentiating flow resistances in the connection ducts provided to the respective layers from each other by differing areas of the discharge ports(144) from each other according to the layers.

2. The cabinet(100) according to claim 1, further comprising:
a ventilation duct(160) for discharging heat generated from the device accommodation spaces(120); and
a heat dissipation fan(180) for discharging hot air from the ventilation duct(160),
wherein the discharge ports(144) of the connection ducts are connected to the ventilation duct(144).

3. The cabinet(100) according to claim 1 or 2, wherein the areas of the discharge ports(174) of the connection ducts(170) are adjustable.

4. The cabinet(100) according to claim 3, wherein the discharge port(174) of each of the connection ducts(170) is formed by a pair of hinge-coupled adjustment segments(170b), each of the adjustment segments having a square bracket-shaped cross section.

5. A cabinet(100) for electric devices, the cabinet comprising:
a plurality of device accommodation spaces(120) defining a plurality of layers for accommodating the electric devices(12); and
a plurality of connection ducts(150) provided to a ventilation side of the device accommodation spaces(120),
wherein each of the connection ducts(150) comprises a damper(152) for adjusting a flow resistance therein,
wherein a flow rate and flow velocity of air passing through each of the connection ducts(150) is adjusted by differentiating the flow resistances caused by the dampers(152) from each other according to the layers.

6. The cabinet(100) according to claim 5, wherein an opening rate is adjustable by adjusting an angle of each of the dampers(152).
